# EUROPÄISCHE PATENTSCHRIFT

(11) **EP 0 436 565 B1**
(45) Veröffentlichungstag und Bekanntmachung des Hinweises auf die Patenterteilung: **10.03.1993**
(21) Anmeldenummer: 89909380.1
(22) Anmeldetag: 23.08.1989
(51) Int. Cl.: H03H 9/64, H03H 9/02

(54) **OBERFLÄCHENWELLEN-INTERDIGITALWANDLER UND OBERFLÄCHENWELLEN-FILTER MIT SYMMETRISCHER ODER VORGEBBAR UNSYMMETRISCHER ÜBERTRAGUNGSCHARAKTERISTIK ZWISCHEN EINGANG UND AUSGANG**
SURFACE WAVE INTERDIGITAL TRANSDUCER AND SURFACE WAVE FILTER WITH SYMMETRICAL OR PREDETERMINED ASYMMETRICAL TRANSFER CHARACTERISTIC BETWEEN INPUT AND OUTPUT
TRANSDUCTEUR INTERDIGITAL D'ONDES DE SURFACE ET FILTRE A ONDES DE SURFACE A CARACTERISTIQUE DE TRANSMISSION SYMETRIQUE OU ASYMETRIQUE DE MANIERE PREDETERMINEE ENTRE ENTREE ET SORTIE

(30) Priorität: 28.09.1988 DE 3832944
(43) Veröffentlichungstag der Anmeldung: 17.07.1991
(73) Patentinhaber: SIEMENS AKTIENGESELLSCHAFT, 80333 München (DE)
(72) Erfinder: ANEMOGIANNIS, Kimon, D-8000 München 60 (DE)
(86) Internationale Anmeldenummer: DE8900552
(87) Internationale Veröffentlichungsnummer: WO9003692

(56) Entgegenhaltungen:
- US-A- 4 468 642
- IEEE 1986 Ultrasonic Symposium, Proceedings, 17-19 November 1986, Williamsburg, VA, volume 1, IEEE, B. FLEISCHMANN et al. : "Rayleigh-mode saw-filters on quartz for timing recovery at frequencies above-1 GHZ", pages 163-167, see figures 1, 2 ; page 164, paragraph : "2. Synthesis of the transducer"
- Patent Abstracts of Japan, volume 2, No. 56, 24 April 1978, page 1406 E 78 ; & JP,A,5320840 (HITASHI SEISAKUSHO K.K.) 25 February 1978, see abstract

## Beschreibung

Die vorliegende Erfindung betrifft einen Interdigitalwandler entsprechend dem Oberbegriff des Patentanspruchs 1 und insbesondere ein Low-Loss-Filter nach dem Oberbegriff des Patentanspruches 2.

Die Übertragungscharakteristik eines Oberflächenwellenfilters wird durch die Geometrie der in dem Filter enthaltenen, auf einem piezoelektrischen Substrat angeordneten elektroakustischen Interdigitalwandler und die Topologie ihrer Anordnung festgelegt. Die akustische Welle, die in dem einen (Eingangs-) Interdigitalwandler angeregt wird, kann bei ihrer Ausbreitung in der Oberfläche des Substrats unterhalb der Finger dieser Wandler durch Reflexionen elektrischer und/oder mechanischer Natur gestört werden. Bekanntermaßen führt dies zu Verzerrungen der Übertragungscharakteristik, Verschiebung der Mittenfrequenz und Reduktion der Bandbreite des betreffenden Filters. Tieferer Grund für derartige Störungen ist die geometrische Abweichung der Anregungszentren und der Reflexionszentren des einzelnen Wandlers voneinander. Solche Störungen machen sich besonders bei Substraten mit hohem Kopplungsfaktor, bei relativ langen Wandlern und/oder bei stark reflektierenden Fingerkanten bemerkbar.

Um derartige Mängel zu beheben, ist es seit langem bekannt, zur Vermeidung derartiger Störungen jeweilige Interdigitalwandler als Splitfinger-Wandler auszugestalten. Bei Splitfinger-Interdigitalwandlern werden die auch dort an den Fingerkanten auftretenden Reflexionen durch destruktive Interferenz unterdrückt. Es hat sich aber gezeigt, daß (auch) Splitfinger-Interdigitalwandler bzw. Filter mit solchen Wandlern eine Unsymmetrie in der Übertragungscharakteristik aufweisen.

Aus der JP-A-53-20840 ist ein für ein Oberflächenwellenfilter vorgesehener Interdigitalwandler bekannt, der neben interdigitalen Splitfinger-Paaren auch interdigital angeordnete Einfachfinger besitzt.

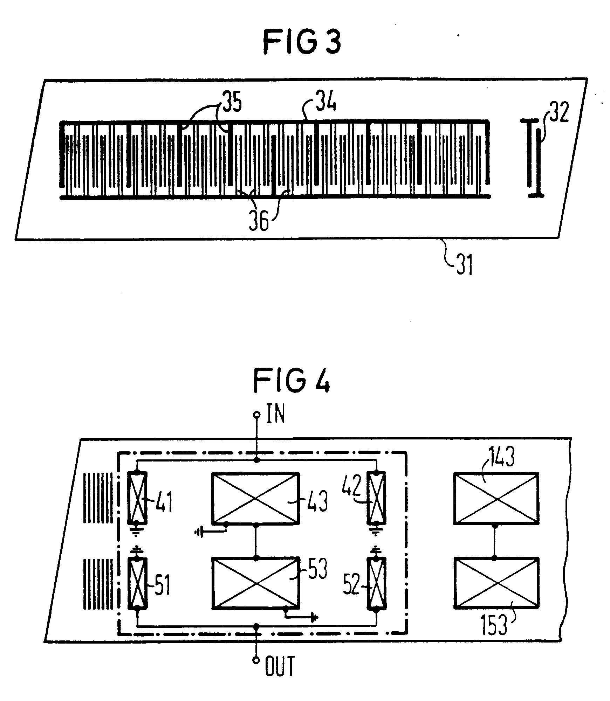

Der Zweck des angegebenen Wandlers mit Splitfingern dieser Druckschrift ist, diejenigen Anteile an Triple-Transit-(Echo-) Signalen (T.-T.-Signal) zu verringern, die bei einem bekannten Splitfinger-Wandler dann auftreten, wenn dieser Wandler an den Wellenwiderstand des Filters gut angepaßt ist. Bekanntermaßen hat der Splitfinger-Wandler ein hohes Maß an Unterdrückung des Triple-Transit-Signals nur bei "schlechter" Anpassung. Die Einfügung der Einfachfinger in den Wandler dieser Druckschrift dient dazu, daß T.-T.-Signal zu verringern, und zwar ohne daß dabei die Übertragungsfunktion des Wandlers bzw. des Filters beeinflußt wird. Hierauf weist insbesondere der Umstand hin, daß beim Wandler dieser Druckschrift die "anstelle" von Splitfingerpaaren dort vorhandenen Einfachfinger sowohl elektrisch angeschlossen als auch elektrisch nicht-angeschlossen sein können (siehe die dortigen Figuren 3 und 4). Ließe man beim Wandler der japanischen Anmeldung die angeschlossenen oder auch nicht-angeschlossenen Einfachfinger weg, würde dies den Verlauf der Übertragungsfunktion nicht ändern, sondern die Übertragungsfunktion würde nur zusätzlich Welligkeiten aufgrund auftretenden T.-T.-Signals aufweisen. Hat ein Wandler dieser Druckschrift nicht-angeschlossene Einfachfinger (Figur 4), besitzt er veränderte Dämpfung.

Die Funktionweise dieses Wandlers beruht auf im Wandler vorgesehenen Phasenverschiebungen, die wiederum auf der Einfügung der Einfachfinger "anstelle" weggelassener Splitfinger beruhen.

Der vorliegenden Beschreibung sind die Figuren 1 bis 6 beigefügt, die zeigen:
Fig. 1 eine typische Übertragungscharakteristik eines Filters mit bekannten Wandlern,
Fig. 2 eine gegenüber Figur 1 gemäß einer Variante der Erfindung symmetrisch gemachte Übertragungscharakteristik,
Fig. 3 ein erfindungsgemäß ausgebildetes Filter,
Fig. 4 ein Filter, mit erfindungsgemäß ausgebildeten Koppelwandlern,
Fig. 5 eine typische Übertragungscharakteristik eines Filters nach Figur 4 mit üblichen Koppelwandlern und
Fig. 6 eine gegenüber Figur 5 verbesserte Übertragungscharakteristik eines Filters nach Figur 4.

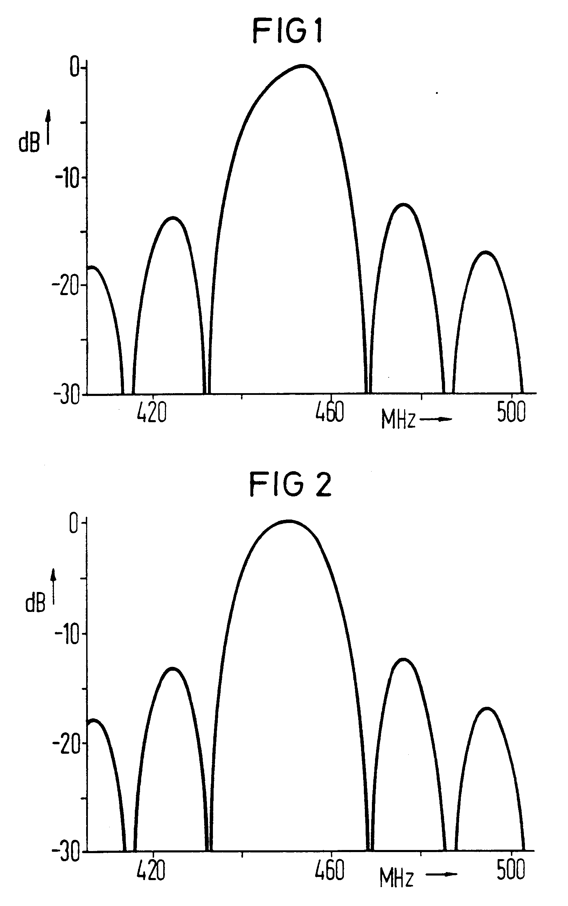

Figur 1 zeigt die Übertragungscharakteristik eines Filters mit zwei Wandlern, einem Zwei-Fingerwandler und einem (bekannten) Splitfinger-Interdigitalwandler, auf Lithiumniobat. Der Splitfingerwandler hat 51 Splitfinger-Paare, die einen Mittenabstand Lambda/2 der Fingerpaare, d.h. Lambda/8-Abstand zwischen den einzelnen Fingern, voneinander haben. Die Metallisierungshöhe (Aluminium) der Finger betrug bei diesem Beispiel 200 nm. Die Übertragungscharakteristik der Figur 1 zeigt zumindest für höherer Ansprüche störende Unsymmetrie, die jedoch geringer ist als sie ein Filter zeigt, das statt Splitfinger-Ausführung üblicherweise verwendete Einfachfinger mit Lambda/2-Abstand voneinander besitzt.

Aufgabe der vorliegenden Erfindung ist es, Maßnahmen anzugeben, mit denen ein Interdigitalwandler mit in hohem Maße symmetrischer Übertragungscharakteristik zu erzielen ist. Eine Weiterbildung dieser Aufgabe ist, ein Filter anzugeben, das eine vorgebbar unsymmetrische Übertragungscharakteristik ohne Notwendigkeit einer Wichtung des Wandlers besitzt.

Die voranstehende Aufgabenstellung wird mit einem Interdigitalwandler nach Patentanspruch 1 gelöst und die weitergehende Aufgabenstellung wird durch ein Filter nach Patentanspruch 2 erfüllt.

Wie bereits oben erwähnt, sind Wandler mit Splitfinger-Ausführung schon lange bekannt. Ihre Anwendung ist aber sehr restriktiv gehandhabt, da Splitfinger-Wandler wegen der um den Faktor 2 geringeren Fingerabstände für Filter vorgegebener Grenzfrequenz schwieriger herzustellen sind oder man sich mit nur halb so hoher Grenzfrequenz zufriedengeben muß.

Die Erfindung sieht vor, in einem Wandler mit ansonsten Splitfingern mit vorgegebener (konstanter) Periodizität der Splitfingerpaare eine jeweilige Anzahl der Splitfingerpaare, verteilt über den Splitfinger-Wandler, durch Einfachfinger (bei unveränderter Periodizität) zu ersetzen. Damit wird zwar in das erfindungsgemäße Filter ein Maß an an sich störenden inneren Reflexionen eingebracht. Anzahl derart ersetzter Finger und Verteilung sind erfindungsgemäß jedoch so gewählt, daß eine an sich noch verbleibende Unsymmetrie eines Splitfinger-Filters vollständig zugunsten einer symmetrischen Übertragungscharakteristik beseitigt wird. Dies zeigt Figur 2. Figur 3 zeigt das erfindungsgemäß ausgebildete Filter, an dem die Übertragungscharakteristik nach Figur 2 ermittelt worden ist.

Mit 31 ist das Substrat bezeichnet. Auf diesem Substrat befinden sich ein Zwei-Finger-(Eingangs-)Wandler 32 und ein erfindungsgemäß ausgebildeter Splitfinger-Paare/Einfachfinger-Wandler 34. Es handelt sich um einen symmetrischen Wandler 34 mit 50 Fingerperioden bzw. 51 Fingern, wovon neun Einfachfinger 35 die gleiche Anzahl Splitfinger-Paare 36 ersetzen.

Eine praktische Bemessungsregel für eine jeweilige Ausführungsform der Erfindung wird nachfolgend angegeben: Regelmäßig vorgegebene Werte sind die Mittenfrequenz, die Bandbreite und die Sperrdämpfung. Weitere Pflichten sind das Erreichen minimaler Einfügungsdämpfung, symmetrische oder vorgegeben unsymmetrische Übertragungscharakteristik und minimierte Welligkeit im Durchlaßbereich.

Die Mittenfrequenz ergibt die Fingerperiode der Splitfinger-Paare (und Einfachfinger) des erfindungsgemäß ausgestalteten Splitfinger-Wandlers. Die Bandbreite bestimmt die Anzahl der Fingerperioden, d.h. die Länge des Wandlers. Bei einer Weglaßwichtung sind nicht alle Fingerperioden mit Splitfinger-Paaren bzw. Einfachfingern besetzt. Die Sperrdämpfung bzw. Selektivität des Filters wird durch eine bekanntermaßen bemessene Wichtung realisiert. Erfindungsgemäß wird die Symmetrie durch teilweisen Ersatz von Splitfinger-Paaren durch Einfachfinger erreicht. Die hierzu gehörige Bemessung wird numerisch ermittelt. Eine bevorzugte Vorgehensweise ist, zunächst eine geringe Anzahl symmetrisch verteilt und periodisch bzw. äquidistant positionierte Splitfinger-Paare durch Einfachfinger zu ersetzen. Suksessive wird die Anzahl der zu ersetzenden Splitfinger-Paare erhöht, bis ein Ergebnis nahe dem Optimum hinsichtlich der vorgegebenen Form, insbesondere symmetrischen Form, der Obertragungscharakteristik erreicht ist. Das Optimum selbst wird dann iterativ ermittelt, z.B. nach dem Hamming-Abstandsverfahren. Mittels Phasenwichtung durch Fingerverschiebung der vorhandenen Einfachfinger kann ggf. notwendige weitere Feinabstimmung erzielt werden.

Es beruht auf dem Erfindungsgedanken, auch ein solches Filter anzugeben, das statt perfekter Symmetrie der Übertragungscharakteristik gezielt vorgegebene Unsymmetrie dieser Charakteristik aufweist. Derartiges läßt sich nämlich erreichen, wenn Anzahl und Verteilung der erfindungsgemäß Splitfinger-Paare ersetzenden Einfachfinger dementsprechend vorgenommen wird. Die zu erreichende vorgegebene Unsymmetrie läßt sich mit der Erfindung schon ohne zusätzliche Wichtung des Wandlers erzielen. Mit z.B. Phasenwichtung kann eine "Feinabstimmung" der Übertragungscharakteristik bewirkt werden. Die inneren Reflexionen des Wandlers werden durch Wahl der Anzahl und Verteilung von Einfachfingern so eingestellt, daß eine Interferenz von angeregten und von erfindungsgemäß reflektierten Wellen zur vorgegebenen Übertragungscharakteristik führt.

Im Zusammenhang mit der Erfindung konnte festgestellt werden, daß eine zusätzliche Fingerwichtung wie Überlappungswichtung, Weglaßwichtung etc. eines nach der Erfindung ausgeführten Wandlers bzw. Filters keinen negativen Einfluß auf die symmetrische bzw. vorgegeben unsymmetrische Form der Übertragungscharakteristik eines erfindungsgemäß ausgestalteten Filters hat.

Ein erfindungsgemäß ausgebildeter Wandler mit Splitfinger-Paaren und Splitfinger-Paare 36 ersetzenden Einfachfingern 35 findet eine besonders vorteilhafte Anwendung in einem Low-Loss-Oberflächenwellenfilter, wie es in der US-A-4 468 642 beschrieben ist. Insbesondere sei auf die dort angegebenen Ausführungsformen nach den Figuren 1, 4 und 5 und auf die in dieser Druckschrift enthaltene Lehre zum technischen Handeln hingewiesen. Die Figur 4 der vorliegenden Erfindung gibt eine Prinzipdarstellung eines solchen bekannten Filters wieder.

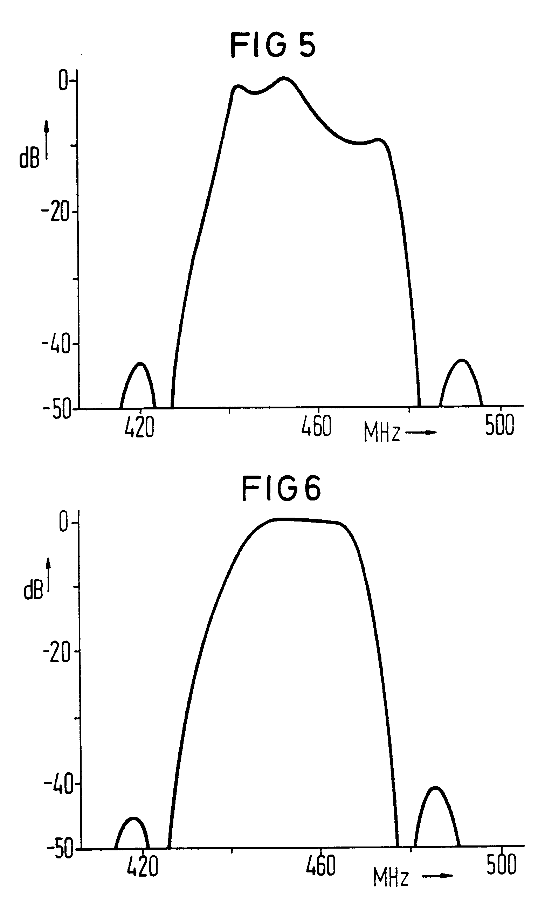

Das Low-Loss-Filter nach der US-A-4 468 642 ist ein solches in Zwei-Spuren-Anordnung. Für dieses Filter wird insbesondere Material mit hohem Kopplungsfaktor verwendet, was aber dazu führt, daß aufgrund innerer Reflexionen in den Wandlern daraus resultierende störende Effekte besonders stark sind. Ein solches bekanntes Low-Loss-Filter besteht aus mindestens sechs Wandlerstrukturen und hat im Regelfall noch vier weitere Strukturen, mit denen an den Enden der beiden Spuren unidirektionale Wirkung für die vier endständigen Wandler bewirkt wird. Die Figur 5 der Patentschrift zeigt eine erweiterte Ausführungsform eines solchen bekannten Filters mit neun, d.h. mit mehr als drei Interdigitalwandler je Spur. Wie ersichtlich, sind fünf Wandler der oberen Spur als Eingangswandler miteinander parallelgeschaltet. Zwischen je zwei solchen Wandlern befindet sich ein als Kopplungswandler zu bezeichnender weiterer Interdigitalwandler. Entsprechendes gilt für die untere Zeile mit parallelgeschalteten Wandlern als Ausgang des Filters. Je ein Kopplungswandler der oberen Reihe ist mit einem Kopplungswandler der unteren Reihe elektrisch verbunden. Es liegt symmetrischer Aufbau der Wandler von oberer Reihe und unterer Reihe des Filters vor.

Zur weiteren Erläuterung der vorliegenden Erfindung genügt es, weiterhin die durch gestrichtelte Linien umgrenzte Zelle des Filters der anliegenden Figur 4 zu beschreiben. Die z.B. als Eingangswandler betriebenen zwei Interdigitalwandler 41 und 42 und der zwischen diesen Wandlern 41 und 42 angeordnete Wandler 43 bilden zusammen eine Eingangs-Wandlerkombination. Entsprechendes gilt für die Ausgangs-Wandlerkombination mit den Wandlern 51, 52 und 53 der unteren Reihe. Mit 143 und 153 sind Koppelwandler des anschließenden, sich wiederholenden Anteils des Filters bezeichnet.

Die beiden erwähnten Kopplungswandler 43 und 53 sind elektrisch miteinander verbunden und bilden ein Paar Koppelwandler. Diese beiden Koppelwandler 43 und 53 sind in ihrer Ausführung identisch und elektrisch parallel geschaltet. Das (jeweilige) Paar Koppelwandler bildet die innerhalb des Filtes vorhandene Verbindung zwischen der Eingangswandler-Kombination und der Ausgangswandler-Kombination. Hinsichtlich der Kopplungswandler 43 und 53 ist darauf hinzuweisen, daß diese symmetrisch oder antisymmetrisch aufgebaute Wandler der (jeweiligen) Zelle dieses Low-Loss-Filters sind. Die auf beiden Seiten der Symmetrieebene (bzw. des Symmetriezentrums bei antisymmetrischem Wandler 43) des Koppelwandlers 43 angeordneten (Eingangs-)Wandler 41 und 42 und der Koppelwandler 43 sind so aufgebaut und angeordnet, daß der Koppelwandler 43 von beiden Wandlern 41, 42 d.h. von beiden Seiten her, Oberflächenwellen-Energie mit gleicher Intensität und mit zueinander gleicher Phase oder in Gegenphase zugeführt erhält.

Wenn man, wie dies Gegenstand der US-A-4 468 642 ist, die Koppelwandler hinsichtlich der Anzahl ihrer interdigitalen Einfachfinger in der dort angegebenen Weise bemißt, erhält man ein Filter mit minimaler Durchgangs- bzw. Einfügungsdämpfung. Wie dort angegeben, weist aber ein solches Low-Loss-Filter Unsymmetrie und Rippel der Übertragungscharakteristik auf. Die gemäß der US-Patentschrift festgelegte Anzahl 2N der Wandlerfinger legt, abhängig vom Substratmaterial, auch die Bandbreite fest.

Es wurde festgestellt, daß bei von der Vorschrift der US-PS abweichender Anzahl N der (Einfach-)Fingerpaare der Koppelstrukturen eine erhebliche Zunahme des Rippels auftritt, so daß man von solchen Maßnahmen in der Praxis Abstand nimmt.

Mit der Erfindung läßt sich ein Filter der Art, wie es in der US-A-4 468 642 im Prinzip angegeben ist, erheblich verbessern, und zwar im Hinblick auf Symmetrie der Übertragungscharakteristik zwischen Eingang und Ausgang dieses Filters. Dies gilt auch für Koppelwandler mit von der Vorschrift nach der US-Patentschrift abweichender Anzahl N der Wandlerfingerpaare.

Bei Anwendung der Erfindung haben die zwei Koppelwandler eines jeweiligen Paares Koppelwandler, so z.B. die Wandler 43 und 53, Splitfinger-Paare und Einfachfinger. Auch hier verhindern die Splitfinger-Paare von ihnen selbst ausgehende innere Reflexionen. Die Einfachfinger bewirken aber gezielt innere Reflexionen im Wandler. Die Einfachfinger sinn in dem ansonsten mit Splitfinger-Paaren ausgerüsteten, hier notwendigerweise symmetrischen oder antisymmetrischen Koppelwand!er symmetrisch oder antisymmetrisch verteilt angeordnet. Die erfindungsgemäß ausgebildeten Koppelwandler 43, 53 sind damit symmetrische oder antisymmetrische Anordnungen auch unter Einbeziehung der Tatsache, daß zwei Arten von Wandlerfingern vorgesehen sind.

Eine erfindungsgemäße Ausführungsform eines Filters nach dem Prinzip der US-Patentschrift bzw. eines Filters nach Figur 4 ist die, bei der die Koppelwandler 43 und 53 je ein Wandler 34 nach Figur 3 sind. Da dieser Wandler 34 des Filter nach Figur 3 ein symmetrischer Wandler ist, was für das dort angegebene Filter nicht notwendig wäre, ist auch die diesbezügliche Randbedingung für das Low-Loss-Filter der Figur 4 erfüllt. Die Wandler 41 und 42 bzw. 51 und 52 sind wieder die Eingangs- bzw. Ausgangswandler.

Ein praktischer Vergleich soll anhand von zwei Beispielen den Fortschritt der Erfindung dokumentieren. Es wurde ein Filter entsprechend Figur 4 (mit je drei Wandlern pro Spur, d.h. mit einem Paar Koppelwandler) hergestellt. Jeder dieser Koppelwandler 43, 53 hatte eine wirksame Länge von 50 (geometrischen) Fingerperioden mit 45 interdigital angeordneten Einfachfingern mit üblichem Lambda/2-Mittenabstand voneinander. Die gegenüber der Periodenanzahl etwas verringerte Anzahl der Einfachfinger beruht auf einer zur Einhaltung der vorgegebenen Bandbreite vorgenommenen Finger-Weglaßwichtung. Die Figur 5 zeigt die zu diesem Filter mit Einfachfingern versehenen Koppelwandlern zugehörige Übertragungscharakteristik, die im Durchlaßbereich, wie erfindungsgemäß erkannt, aufgrund starker innerer Reflexionen, die ersichtlich erheblichen Unregelmäßigkeiten aufzeigt. Das erfindungsgemäß ausgebildete Vergleichsbeispiel mit wiederum 51 Fingerperioden und 45 Fingern je Koppelwandler 43 und 53, jedoch mit 25 Splitfinger-Paaren und 20 erfindungsgemäß vorgesehenen Einfachfingern je Wandler 43, 53 in jeweils symmetrischer Anordnung, ergibt die Filtercharakteristik nach Figur 6. Der Vergleich der Figuren 6 und 5 zeigt den mit der Erfindung erreichten Fortschritt.

Die erfindungsgemäße Ausführung eines Splitfinger-Wandlers mit symmetrischem oder antisymmetrischem Austausch von Splitfinger-Paaren durch Einfachfinger wird hier als partielles Splitting (partial splitting) bezeichnet.

Eine vorgegeben unsymmetrische Übertragungscharakteristik läßt sich für ein Filter, z.B. eines nach Fig. 3 oder nach Fig. 4, erreichen, indem man in dem Splitfinger-Paare-Wandler 34; 43, 53 eine solche Anzahl und eine solche Verteilung von Einfachfingern, die Splitfinger ersetzen, vorsieht, die die Zielfunktion ergeben. Es werden dazu die oben für symmetrische Übertragungscharakteristik angewendeten Bemessungsverfahren, eingeschlossen Iterationen, ausgeführt.

Zur Unterdrückung von Ripples bei einem wie oben beschriebenen low-loss-Filter, die auf Doppeltransit-Signale beruhen, ist es zweckmäßig die Wandler 41 bis 53 so voneinander im Abstand anzuordnen, wie dies in der Zeitgleichen Anmeldung WO 90/03690 beschrieben ist.

## Patentansprüche

1. Elektroakustischer Interdigitalwandler (34) für Oberflächenwellenfilter, der Splitfinger-Paare (36) und Einfachfinger (35) umfaßt, von denen die Splitfinger-Paare einer vorgegebenen örtlichen periodischen Verteilung entsprechend angeordnet sind, **gekennzeichnet dadurch,**
daß die Einfachfinger (35) in dem Wandler (34) ebenfalls dieser örtlichen periodischen Verteilung entsprechend so verteilt angeordnet sind, daß in dem Wandler anteilige innere Reflexionen vorliegen, die eine symmetrische oder gezielt unsymmetrische Übertragungscharakteristik dieses Filters ergeben.

2. Oberflächenwellenfilter
mit mindestens zwei Eingangs-Interdigitalwandlern (41, 42), die bezogen auf den Eingangsanschluß des Filters elektrisch parallelgeschaltet sind,
mit mindestens zwei Ausgangs-Interdigitalwandlern (51, 52), die bezogen auf den Ausgangsanschluß des Filters elektrisch parallelgeschaltet sind,
und mit mindestens einem Paar Koppelwandler (43, 53), dessen jeweils zwei Koppelwandler (43, 53) identisch ausgeführt und elektrisch parallelgeschaltet sind und
wobei zwei Eingangs-Interdigitalwandler (41, 42) und der eine Koppelwandler (43) des Paares der Koppelwandler eine Eingangs-Kombination des Filtes bilden und in einer ersten Spur angeordnet sind und zwei Ausgangs-Interdigitalwandler (51, 52) und der andere Koppelwandler (53) des Paares der Koppelwandler eine Ausgangs-Kombination bilden und in einer zweiten, zur ersten Spur parallelen Spur angeordnet sind, wobei in der Eingangs-Kombination und in der Ausgangs-Kombination der zugehörige Koppelwandler zwischen den zwei Eingangs- bzw. Ausgangs-Interdigitalwandlern dieser jeweiligen Kombination symmetrisch angeordnet ist, der Koppelwandler (43, 53) symmetrisch oder antisymmetrisch ausgebildet ist und der jeweilige Koppelwandler gleiche Oberflächenwellen-Energie in Phase oder Gegenphase von den Interdigitalwandlern der betreffenden Kombination erhält, **gekennzeichnet dadurch,**
daß zum Erreichen einer symmetrischen Übertragungscharakteristik zwischen Eingang und Ausgang des Filters die zwei Koppelwandler (43, 53) eines jeweiligen Paares Koppelwandler als Wandler nach Anspruch 1 ausgebildet sind, und daß die Anordnung der Splitfinger-Paare (36) einerseits und die Anordnung der Einfachfinger (35) andererseits symmetrisch oder antisymmetrisch im jeweiligen Koppelwandler (43, 53) ist.

3. Oberflächenwellenfilter nach Anspruch 2,
mit vorgegeben unsymmetrischer Übertragungscharakteristik, **gekennzeichnet dadurch,**
daß die Anzahl und Verteilung der Einfachfinger (35), die innere Reflexionszentren bewirken, zwischen den Splitfinger-Paaren (36) so bemessen ist, daß sich die unsymmetrische Zielfunktion ergibt.

## Claims

1. Electro-acoustic interdigital transducer (34) for a surface wave filter which comprises split-finger pairs (36) and single fingers (35), of which the split-finger pairs are disposed in accordance with a predetermined local periodic distribution, characterised in that the single fingers (35) in the transducer (34) are also disposed distributed in accordance with this local periodic distribution in such a manner that proportional internal reflections are present in the transducer which result in a symmetric or deliberately assymmetric transfer characteristic of this filter.

2. Surface wave filter having at least two input interdigital transducers (41, 42) which, referred to the input connection of the filter, are electrically connected in parallel, having at least two output interdigital transducers (51, 52) which, referred to the output connection of the filter, are electrically connected in parallel, and having at least one pair of coupling transducers (43, 53), the in each case two coupling transducers (43, 53) of which are identically constructed and are electrically connected in parallel and in which two input interdigital transducers (41, 42) and one coupling transducer (43) of the pair of coupling transducers form an input combination of the filter and are arranged in a first track and two output interdigital transducers (51, 52) and the other coupling transducer (53) of the pair of coupling transducers form an output combination and are disposed in a second track parallel to the first track, the associated coupling transducer in the input combination and in the output combination being symmetrically disposed between the two input and, respectively, output interdigital transducers of this respective combination, the coupling transducer (43, 53) being symmetrically or antisymmetrically constructed and the respective coupling transducer receiving equal surface wave energy in phase or opposite phase from the interdigital transducers of the relevant combination, characterised in that, for achieving a symmetric transfer characteristic between input and output of the filter, the two coupling transducers (43, 53) of a respective pair of coupling transducers are constructed as transducers according to Claim 1 and in that the arrangement of the split-finger pairs (36), on the one hand, and the arrangement of the single fingers (35), on the other hand, is symmetric or antisymmetric in the respective coupling transducer (43, 53).

3. Surface wave filter according to Claim 2, having a predetermined asymmetric transfer characteristic, characterised in that the number and distribution of the single fingers (35) which produce internal reflection centres, between the split-finger pairs (36) is dimensioned in such a manner that the asymmetric objective function is obtained.

## Revendications

1. Transducteur interdigital (34) électroacoustique pour un filtre à ondes de surface, qui comporte des couples de doigts scindés (36) et des doigts simples (35), parmi lesquels les couples de doigts scindés correspondant sont disposés suivant une distribution locale et périodique déterminée à l'avance, caractérisé en ce que les doigts simples (35) sont également répartis dans le transducteur (34) suivant cette distribution locale et périodique, de sorte que soient présentes dans le transducteur, des réflexions internes proportionnelles, qui donnent à ce filtre une caractéristique de transmission symétrique ou asymétrique souhaitée.

2. Filtre à ondes de surface comportant
au moins deux transducteurs interdigitaux d'entrée (41, 42) qui, par rapport à la connexion d'entrée du filtre, sont montés électriquement en parallèle,
au moins deux transducteurs interdigitaux de sortie (51, 52) qui, par rapport à la connexion de sortie du filtre, sont montés électriquement en parallèle,
et au moins un couple de transducteurs de couplage (43, 53) dont respectivement deux transducteurs de couplage (43, 53) sont réalisés de façon identique et sont montés électriquement en parallèle, la réalisation étant telle que deux transducteurs interdigitaux d'entrée (41, 42) et un premier (43) des transducteurs de couplage du couple de transducteurs de couplage, forment une combinaison d'entrée du filtre et sont disposés dans une première voie ou piste, et que deux transducteurs interdigitaux de sortie (51, 52) et l'autre transducteur de couplage (53) du couple de transducteurs de couplage, forment une combinaison de sortie du filtre et sont disposés dans une seconde voie ou piste parallèle à la première, alors que dans la combinaison d'entrée et dans la combinaison de sortie, le transducteur de couplage associé est disposé de manière symétrique entre les deux transducteurs interdigitaux d'entrée et de sortie respectivement de cette combinaison, et que le transducteur de couplage (43, 53) est réalisé de façon symétrique ou anti-symétrique, et que le transducteur de couplage concerné reçoit une même énergie d'ondes de surface, en phase ou en opposition de phase, du transducteur interdigital de la combinaison concernée,
caractérisé en ce que,
pour obtenir une caractéristique de transmission symétrique entre l'entrée et la sortie du filtre, !es deux transducteurs de couplage (43, 53) du couple respectif de transducteurs de couplage sont réalisés selon des transducteurs de la revendication 1, et en ce que la disposition des couples de doigts scindés (36), d'une part, et la disposition des doigts simples (35), d'autre part, est, respectivement dans le transducteur de couplage (43, 53), symétrique ou anti-symétrique.

3. Filtre à ondes de surface suivant la revendication 2, à caractéristique de transmission asymétrique déterminée à l'avance,
caractérisé en ce que,
le nombre et la répartition des doigts simples (35), qui créent des centres de réflexion, sont dimensionnés entre les couples de doigts scindés (36) pour l'obtention de la fonction d'asymétrie voulue.
